# EUROPEAN PATENT SPECIFICATION

(11) **EP 3 376 660 B1**
(45) Date of publication and mention of the grant of the patent: **18.12.2019**
(21) Application number: 17752979.9
(22) Date of filing: 02.02.2017
(51) Int. Cl.: H02M 7/48, H02M 1/08, H03K 17/16, H02M 1/32, H02M 1/00, H02M 7/5395, H02M 1/38

(54) **CONTROL DEVICE, INVERTER, CONTROL METHOD, AND PROGRAM**
STEUERUNGSVORRICHTUNG, UMRICHTER, STEUERUNGSVERFAHREN UND PROGRAMM
DISPOSITIF DE COMMANDE, ONDULEUR, PROCÉDÉ DE COMMANDE ET PROGRAMME

(30) Priority: 19.02.2016 JP 2016029802
(43) Date of publication of application: 19.09.2018
(73) Proprietor: Mitsubishi Heavy Industries, Ltd., Tokyo 108-8215 (JP)
(72) Inventor: KOMIYA, Shinichi, Tokyo 108-8215 (JP); SHIMIZU, Kenji, Tokyo 108-8215 (JP); SUMITO, Kiyotaka, Tokyo 108-8215 (JP); SUMIYA, Atsuyuki, Tokyo 108-8215 (JP)
(74) Representative: Henkel & Partner mbB
(86) International application number: PCT/JP2017/003792
(87) International publication number: WO 2017/141716

(56) References cited:
- WO-A1-2016/009719
- JP-A- H0 398 470
- JP-A- 2014 073 027
- US-A- 5 365 118

## Description

### Technical Field

The present invention relates to a control device, an inverter, a control method, and a program.

This application claims priority to Japanese Patent Application No. 2016-029802 filed in Japan on February 19, 2016.

### Background Art

In an air conditioner, an inverter which is a power conversion circuit generating drive AC power for driving a compressor freely is mounted.

Switching elements for high power such as an insulated gate bipolar transistor (IGBT) that handle high power are widely used for inverters. Such an inverter is used, for example, in the form of a half bridge circuit in which two switching elements alternately drive a load. Furthermore, the inverter as described above is often driven by pulse width modulation (PWM) control, using a control device such as a microcomputer.

In the half bridge circuit in which the two switching elements are turned on and off alternately and repeatedly, a phenomenon (negative voltage surge) in which a VS voltage (load driving voltage) temporarily falls to a voltage lower than the ground potential (GND potential) due to the inductance component parasitic on the load (motor), a routing wiring, or the like is known.

It is known that the negative voltage surge not only causes a malfunction of the pulse width modulation control in the control device but also can cause failure of the control device according to the application of the overvoltage.

Various means of trying to suppress the negative voltage surge have been studied (see PTLs 1 to 3). For example, PTL 1 discloses a method of connecting a clamp diode in a forward direction from a COM terminal (a terminal connected to GND) to a VS terminal (a terminal connected to a VS voltage wiring).

### Citation List

### Patent Literature

[PTL 1] Japanese Patent No. 5503897
[PTL 2] Japanese Patent No. 5435138
[PTL 3] Pamphlet of International Publication No. 2015/029456

Documents WO2016/009719 and US5365118 are prior art to the present application.

### Summary of Invention

### Technical Problem

In the case of adding a clamp diode as a separate element, it is necessary to secure a creepage distance, a mounting area, and the like for conforming to the specifications of electronic parts, depending on the mounting mode. Therefore, the clamp diode can be disposed in a position away from the control device and the switching elements. Then, the wiring length from the control device and the switching elements to the clamp diodes is lengthened, and a sufficient suppression effect against the negative voltage surge cannot be expected in some cases. In addition, the addition of the clamp diode leads to an increase in a substrate area and an increase in a manufacturing cost.

The present invention has been made in view of the a bove problems, and an object is to provide a control devic e, an inverter, a control method, and a program capable of suppressing the occurrence of a malfunction based on nega tive voltage surge without adding a separate element.

### Solution to Problem

According to an aspect of the present invention, there is provided a control device which performs pulse width modulation control of an inverter including a pulse width calculation unit that calculates a pulse width calculation value indicating a pulse width of a command signal to be output at each carrier cycle; and a signal output unit that outputs the command signal of the pulse width indicated by the pulse width calculation value such that a starting off period and an ending off period in the carrier cycle coincide with each other, at each carrier cycle, in which in a case where the pulse width calculation value is larger than a predetermined pulse width upper limit value, the signal output unit outputs the command signal of a pulse width indicated by the pulse width upper limit value, instead of the pulse width calculation value.

Further, according to the aspect of the present invention, the pulse width upper limit value is a value obtained by subtracting twice a predetermined off period limit value from the carrier cycle, and the off period limit value is defined as a period from a time when the command signal is turned off to a time of recovery from negative voltage surge generated due to turning off of a switching element which operates based on the command signal.

Further, according to the aspect of the present invention, in a case where the pulse width calculation value coincides with the carrier cycle, the signal output unit outputs the command signal of a pulse width indicated by the pulse width calculation value coinciding with the carrier cycle, instead of the pulse width upper limit value.

Further, according to the aspect of the present invention, in a case where the pulse width calculation value is smaller than a predetermined pulse width lower limit value, the signal output unit outputs the command signal of a pulse width indicated by the pulse width lower limit value, instead of the pulse width calculation value.

Further, according to the aspect of the present invention, the above-described control device further includes a limit value learning unit that determines whether or not a measurement value of an inverter current flowing through the inverter is normal, based on a pulse width of the command signal, and lowers the pulse width upper limit value in a case where it is determined that the measurement value of the inverter current is abnormal.

Further, according to the aspect of the present invention, the limit value learning unit raises the pulse width upper limit value in a case where it is determined that the measurement value of the inverter current is normal.

Further, according to the aspect of the present invention, the above-described control device further includes a limit value setting unit that sets the pulse width upper limit value to a value corresponding to the measurement value of the inverter current flowing through the inverter.

Further, according to the aspect of the present invention, an inverter includes the above-described control device, and a switching element drive circuit that drives a switching element based on the command signal from the control device, and the switching element.

Further, according to the aspect of the present invention, the control device, the switching element drive circuit, and the switching element are implemented in different IC packages, respectively.

Further, according to another aspect of the present invention, there is provided a control method for performing pulse width modulation control of an inverter including a pulse width calculation step of calculating a pulse width calculation value indicating a pulse width of a command signal to be output at each carrier cycle; and a signal output step of outputting the command signal of the pulse width indicated by the pulse width calculation value such that a starting off period and an ending off period in the carrier cycle coincide with each other, at each carrier cycle, in which in the signal output step, in a case where the pulse width calculation value is larger than a predetermined pulse width upper limit value, the command signal of a pulse width indicated by the pulse width upper limit value is output, instead of the pulse width calculation value.

Further, according to still another aspect of the present invention, there is provided a program causing a control device which performs pulse width modulation control of an inverter to function as: a pulse width calculation unit that calculates a pulse width calculation value indicating a pulse width of a command signal to be output at each carrier cycle; and a signal output unit that outputs the command signal of the pulse width indicated by the pulse width calculation value such that a starting off period and an ending off period in the carrier cycle coincide with each other, at each carrier cycle, in which in a case where the pulse width calculation value is larger than a predetermined pulse width upper limit value, the signal output unit outputs the command signal of a pulse width indicated by the pulse width upper limit value, instead of the pulse width calculation value.

### Advantageous Effects of Invention

According to the control device, the inverter, the control method and the program, described above, it is possible to suppress the occurrence of a malfunction based on negative voltage surge without adding a separate element.

### Brief Description of Drawings

Fig. 1 is a diagram illustrating a circuit configuration of an inverter according to a first embodiment.
Fig. 2 is a diagram illustrating the circuit configuration of the inverter according to the first embodiment in more detail.
Fig. 3 is a diagram illustrating a functional configuration of a CPU according to the first embodiment.
Fig. 4 is a diagram for explaining a function of a limit determination unit according to the first embodiment.
Fig. 5 is a diagram illustrating a process flow of the CPU according to the first embodiment.
Fig. 6 is a diagram for explaining an example of a process of the CPU according to the first embodiment.
Fig. 7 is a diagram illustrating a functional configuration of a CPU according to a second embodiment.
Fig. 8 is a diagram illustrating a first process flow of the CPU according to the second embodiment.
Fig. 9 is a diagram for explaining a function of a limit value learning unit according to the second embodiment.
Fig. 10 is a diagram illustrating a second process flow of the CPU according to the second embodiment.
Fig. 11 is a diagram illustrating a functional configuration of a CPU according to a third embodiment.
Fig. 12 is a diagram illustrating a process flow of the CPU according to the third embodiment.
Fig. 13 is a diagram for explaining a function of a limit value setting unit according to the third embodiment. Description of Embodiments

### <First Embodiment>

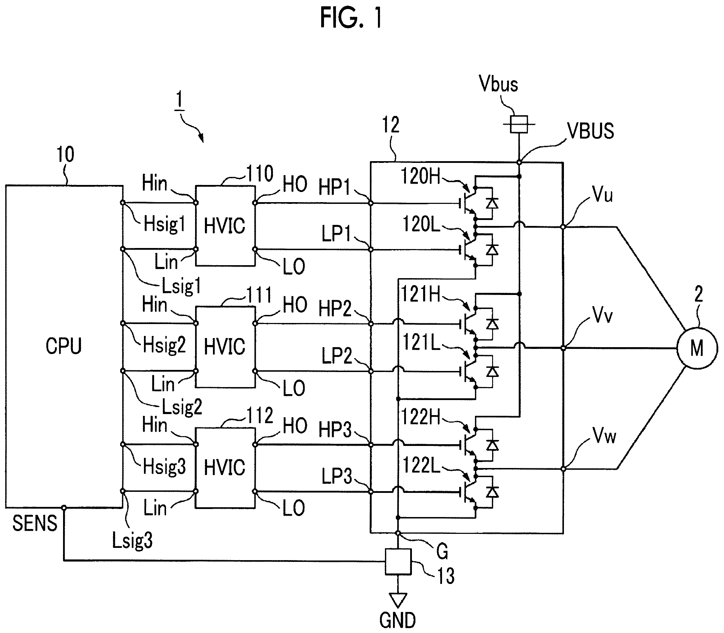

First, an inverter according to a first embodiment will be described with reference to Fig. 1 to Fig. 6.

### (Circuit Configuration of Inverter)

Fig. 1 is a diagram illustrating a circuit configuration of an inverter according to the first embodiment.

The inverter 1 shown in Fig. 1 is a power conversion circuit that converts DC power output from a converter (AC-DC power conversion circuit) (not shown) into three-phase AC power for driving a motor 2 (compressor motor) which is a load, as desired, and outputs the three-phase AC power.

As illustrated in Fig. 1, the inverter 1 includes a CPU 10 (control device), three high voltage ICs 110, 111, 112 (switching element drive circuit), and a switching element IC 12.

In addition, in the present embodiment, the CPU 10, the three high voltage ICs 110, 111, 112, and the switching element IC 12 are separately mounted on one or more circuit boards in separate IC packages.

The CPU 10 (control device) is a processor integrated circuit (IC) that controls the entire operation of the inverter 1, and, for example, a general-purpose microcomputer or the like is used. The CPU 10 outputs a command signal based on the pulse width modulation control (hereinafter also referred to as "PWM control"), and controls ON/OFF of the high voltage switching element (such as switching elements 120H, 120L) through the high voltage ICs 110, 111, 112 to be described later.

Specific functions and process flows of the CPU 10 will be described later.

The high voltage ICs 110, 111, and 112 (switching element drive circuits) are high voltage ICs (HVIC: high Voltage IC) for driving switching elements 120H, 120L and the like which will be described later. The high voltage IC 110 converts the command signals input from the CPU 10 into driving signals for driving the switching elements 120H, 120L and the like and outputs the driving signals. The three high voltage ICs 110, 111, and 112 are provided corresponding to phases of three-phase AC power output toward the motor 2.

The switching element IC 12 is an IC including six switching elements 120H, 120L, 121H, 121L, 122H, and 122L. The switching element 120H, 120L, 121H, 121L, 122H, and 122L are semiconductor elements (power transistors) that can handle high power, and are, for example, insulated gate bipolar transistors (IGBTs).

An input terminal VBUS of the switching element IC 12 is connected to an output source (not shown) of the DC voltage V bus. The input terminal G of the switching element IC 12 is connected to the ground point GND which provides the ground potential (0 V). The DC voltage Vbus is, for example, DC 600 V or the like.

The switching element 120H and the switching element 120L are connected in series between the output source of the DC voltage Vbus and the ground point GND to constitute a half bridge circuit. The switching element 120H performs a switching operation (is turned on or off) on the high potential side (high side) of the half bridge circuit, and the switching element 120L performs a switching operation on the low potential side (low side) of the half bridge circuit.

The switching element 121H and the switching element 121L, and the switching element 122H and the switching element 122L also constitute the same half bridge circuit similar to the switching element 120H and the switching element 120L, respectively. Each of the three half bridge circuits is provided corresponding to each phase of three-phase AC power output toward the motor 2.

The command signals (command signals based on the PWM control) output from the output terminals Hsig1, Lsig1 by the CPU 10 are respectively input to the input terminals Hin, Lin of the high voltage IC 110. The high voltage IC 110 converts the command signals input from the CPU 10 into drive signals for driving the switching elements 120H and 120L in the switching element IC 12. Here, the driving signal is a signal in which the voltage level of the input command signal is raised to the gate voltage level at which ON/OFF of the switching elements 120H and 120L can be controlled.

The high voltage IC 110 outputs a driving signal for driving the switching element 120H (high potential side of the half bridge circuit) from the output terminal HO. Further, the high voltage IC 110 outputs a driving signal for driving the switching element 120L (low potential side of the half bridge circuit) from the output terminal LO.

The driving signal output from the output terminal HO of the high voltage IC 110 is input to the input terminal HP1 of the switching element IC 12. Further, the driving signal output from the output terminal LO of the high voltage IC 110 is input to the input terminal LP1 of the switching element IC 12. The driving signal input to the input terminal HP1 drives the switching element 120H on the high potential side of the half bridge circuit. Further, the driving signal input to the input terminal LP1 drives the switching element 120L on the low potential side of the half bridge circuit. The switching elements 120H and 120L are turned on or off, with the respective driving signals input to the input terminals HP1 and LP1 as gate inputs, respectively.

The half bridge circuit including the switching element 120H and the switching element 120L generates AC power corresponding to one phase (U phase) of the three-phase AC power and outputs it to the motor 2 through the output terminal Vu.

Further, the command signals output from the output terminals Hsig2, Lsig2 by the CPU 10 are input to the input terminals Hin, Lin of the high voltage IC 111, respectively. The high voltage IC 111 converts a command signal input from the CPU 10 into a driving signal for driving the switching elements 121H and 121L inside the switching element IC 12.

The high voltage IC 111 outputs a driving signal for driving the switching element 121H from the output terminal HO. Further, the high voltage IC 111 outputs a driving signal for driving the switching element 121L from the output terminal LO.

The driving signal output from the output terminal HO of the high voltage IC 111 is input to the input terminal HP2 of the switching element IC 12. Further, the driving signal output from the output terminal LO of the high voltage IC 111 is input to the input terminal LP2 of the switching element IC 12. The driving signal input to the input terminal HP2 drives the switching element 121H on the high potential side of the half bridge circuit. Further, the driving signal input to the input terminal LP2 drives the switching element 121L on the low potential side of the half bridge circuit. The switching elements 121H and 121L are turned on or off with the respective driving signals input to the input terminals HP2 and LP2 as gate inputs, respectively.

The half bridge circuit including the switching element 121H and the switching element 121L generates AC power corresponding to one phase (V phase) of the three-phase AC power and outputs it from the output terminal Vv.

Further, the command signals output from the output terminals Hsig3, Lsig3 by the CPU 10 are input to the input terminals Hin, Lin of the high voltage IC 112, respectively. The high voltage IC 112 converts a command signal input from the CPU 10 into a driving signal for driving the switching elements 122H and 122L inside the switching element IC 12.

The high voltage IC 112 outputs a driving signal for driving the switching element 122H from the output terminal HO. Further, the high voltage IC 112 outputs a driving signal for driving the switching element 122L from the output terminal LO.

The driving signal output from the output terminal HO of the high voltage IC 112 is input to the input terminal HP3 of the switching element IC 12. Further, the driving signal output from the output terminal LO of the high voltage IC 112 is input to the input terminal LP3 of the switching element IC 12. The driving signal input to the input terminal HP3 drives the switching element 122H on the high potential side of the half bridge circuit. Further, the driving signal input to the input terminal LP3 drives the switching element 122L on the low potential side of the half bridge circuit. The switching elements 122H and 122L are turned on or off with the respective driving signals input to the input terminals HP3 and LP3 as gate inputs, respectively.

The half bridge circuit including the switching element 122H and the switching element 122L generates AC power corresponding to one phase (W phase) of the three-phase AC power and outputs it from the output terminal Vw.

The current sensor 13 is configured to detect the current (inverter current) flowing from the low potential side of the three half bridge circuits to the ground point GND. The current sensor 13 is configured with, for example, a shunt resistor connected on a wiring connected to the ground point GND, or the like.

The current sensor 13 outputs a detection signal indicating the detection result of the inverter current toward the input terminal SENS of the CPU 10.

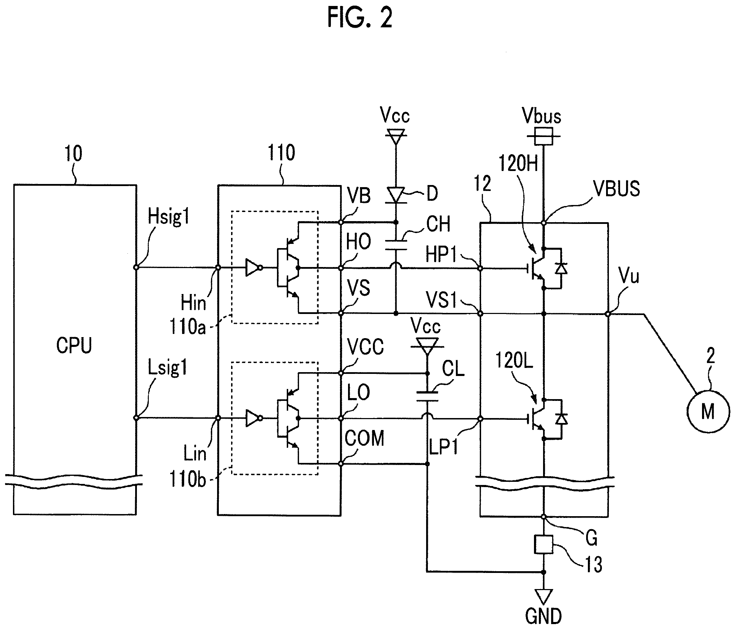

Fig. 2 is a diagram illustrating the circuit configuration of the inverter according to the first embodiment in more detail.

The circuit shown in Fig. 2 shows in detail the connection relationship between the high voltage IC 110 and the switching elements 120H, 120L. Since the connection relationship between the high voltage IC 111 and the switching elements 121H, 121L, and the connection relationship between the high voltage IC 112 and the switching elements 122H, 122L are the same as the connection relationship between the high voltage IC 110 and the switching elements 120H, 120L, shown in Fig. 2, illustration thereof is omitted.

As illustrated in Fig. 2, the input terminal VCC of the high voltage IC 110 is connected to an output source (a driving power supply not shown) of the DC voltage Vcc. The input terminal COM of the high voltage IC 110 is connected to the ground point GND. The DC voltage Vcc is, for example, DC 15 V or the like

The high voltage IC 110 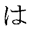 includes a high-side drive circuit 110a and a low-side drive circuit 110b.

The high-side drive circuit 110a converts a command signal input from the CPU 10 through the input terminal Hin into a driving signal for driving the switching element 120H.

The high-side drive circuit 110a operates based on the bootstrap voltage Vb input from the input terminal VB and the load driving voltage Vs input from the input terminal VS. The input terminal VS of the high voltage IC 110 is connected to the load driving voltage output terminal VS1 of the switching element IC 12.

Here, the load driving voltage Vs is a voltage for sending the AC power corresponding to the U phase to the load (the motor 2) to drive it, which occurs between the switching element 120H and the switching element 120L. In addition, the bootstrap voltage Vb becomes a value that is always higher than the load driving voltage Vs by a constant potential difference by the bootstrap circuit including the diode element D and the capacitor element CH, and is input to the input terminal VB.

The low-side drive circuit 110b converts a command signal input from the CPU 10 through the input terminal Lin into a driving signal for driving the switching element 120L.

The low-side drive circuit 110b operates based on the DC voltage Vcc input from the input terminal VCC and the ground potential (0 V) input from the input terminal COM.

A capacitor element CL provided as a countermeasure against noise is connected between the input terminal VCC and the input terminal COM.

### (Functional Configuration of CPU)

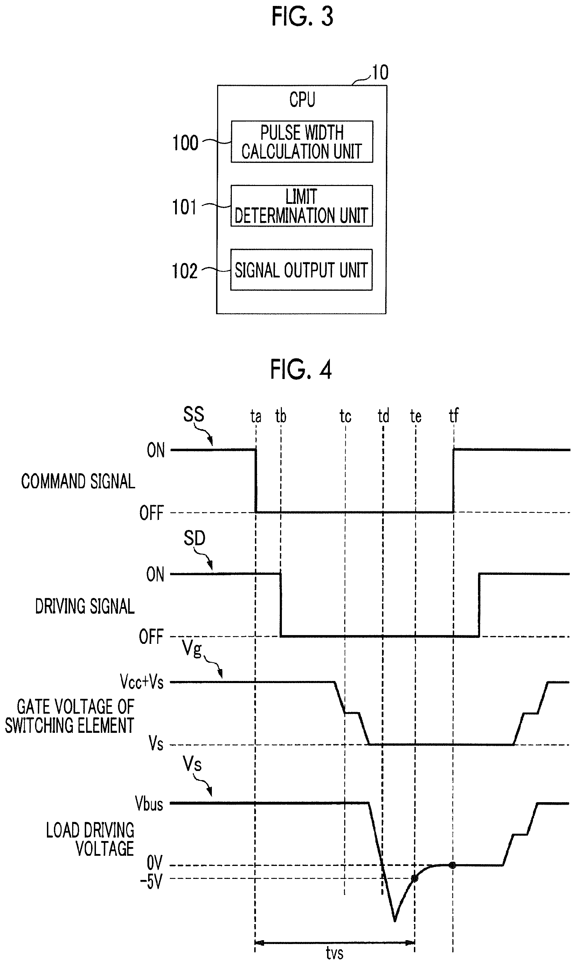

Fig. 3 is a diagram illustrating a functional configuration of the CPU according to the first embodiment.

As illustrated in Fig. 3, CPU 10 exercises functions as a pulse width calculation unit 100, a limit determination unit 101, and a signal output unit 102.

The pulse width calculation unit 100 calculates a pulse width calculation value Tpw_cal indicating a pulse width of a command signal to be output at every predetermined carrier cycle TC. For example, in a case of attempting to output a sinusoidal AC voltage corresponding to one phase among the three-phase AC power, the pulse width calculation unit 100 sequentially changes and outputs the pulse width of the command signal (based on the PWM control) for each carrier cycle TC such that the output voltage becomes the sinusoidal wave.

Here, the "carrier cycle" is a cycle for outputting a "pulse" (rectangular wave) forming a command signal in the PWM control, and is, for example, 148.8 µs (carrier frequency: 6.72 kHz) or the like.

The limit determination unit 101 determines whether or not the pulse width calculation value Tpw_cal calculated by the pulse width calculation unit 100 is larger than a predetermined pulse width upper limit value and whether or not it is smaller than a predetermined pulse width lower limit value. The pulse width upper limit value and the pulse width lower limit value will be described later.

The signal output unit 102 outputs a command signal of a pulse width indicated by the pulse width calculation value Tpw_cal calculated by the pulse width calculation unit 100 such that the starting off period and the ending off period in the carrier cycle TC coincide for each carrier cycle TC.

Further, the signal output unit 102 changes the pulse width of the command signal to a value different from the pulse width calculation value Tpw_cal, based on the determination result of the limit determination unit 101.

### (Function of Limit Determination Unit)

Fig. 4 is a diagram for explaining the function of a limit determination unit according to the first embodiment.

The waveforms shown in Fig. 4 represent time-dependent changes of a command signal SS output from the output terminal Hsig1 by the CPU 10, a driving signal SD output from the output terminal HO by the high voltage IC 110, a gate voltage Vg applied to the gate terminal of the switching element 120H, and the load driving voltage Vs.

Hereinafter, with reference to the example of each of the waveforms shown in Fig. 4, the off period limit value Tpw_off_lim, which is a parameter that the limit determination unit 101 uses as a criterion, will be described.

In the example shown in Fig. 4, the CPU 10 causes the command signal SS to turn off at a certain time ta. Then, the driving signal SD output from the high voltage IC 110 is also turned off (time tb) after a slight delay from the OFF (time ta) of the command signal SS. The gate voltage Vg of the switching element 120H is turned off (time tc) after a further delay from OFF (time tb) of the driving signal SD. The load driving voltage Vs is turned off (reaches 0 V) (time td) after further delay from the OFF (time tc) of the gate voltage Vg.

However, at this time (time td), due to the inductor component parasitic on the load (motor 2), wiring, and the like, negative voltage surge is generated in order to maintain the AC current flowing in the load. With the negative voltage surge, the load driving voltage Vs falls to a potential lower than 0 V. After a lapse of a predetermined time from time td, it recovers to the voltage level (-5 V) at which a safety operation is guaranteed (time te).

Here, it is known that when the CPU 10 turns on the command signal SS during the occurrence of the negative voltage surge (the period from the time td to the time te), a malfunction occurs in the high voltage IC 110 and a driving signal SD corresponding to the turning on of the command signal SS is not output (it remains off) in some cases. When such a malfunction occurs, normal waveform PWM control is not performed, so distortion occurs in the waveform (sinusoidal wave) of the three-phase AC power sent to the motor 2.

In order to prevent such a malfunction as described above, the CPU 10 performs control such that a period (from time ta to time tf) from a time when the command signal SS is turned off until the next time the command signal SS is turned on becomes always larger than a period (recovery period tvs) from a time when the command signal SS is turned off to a time of recovery from the negative voltage surge.

In the present embodiment, the limit determination unit 101 stores a predetermined off period limit value Tpw_off_lim. Here, the off period limit value Tpw_off_lim is defined by using the measurement result of the recovery period tvs acquired in advance.

For example, in a case where the recovery period tvs is 2.5 µs as a result of preliminary measurement, the off period limit value Tpw_off_lim is defined as "2.5 µs".

### (CPU Process flow)

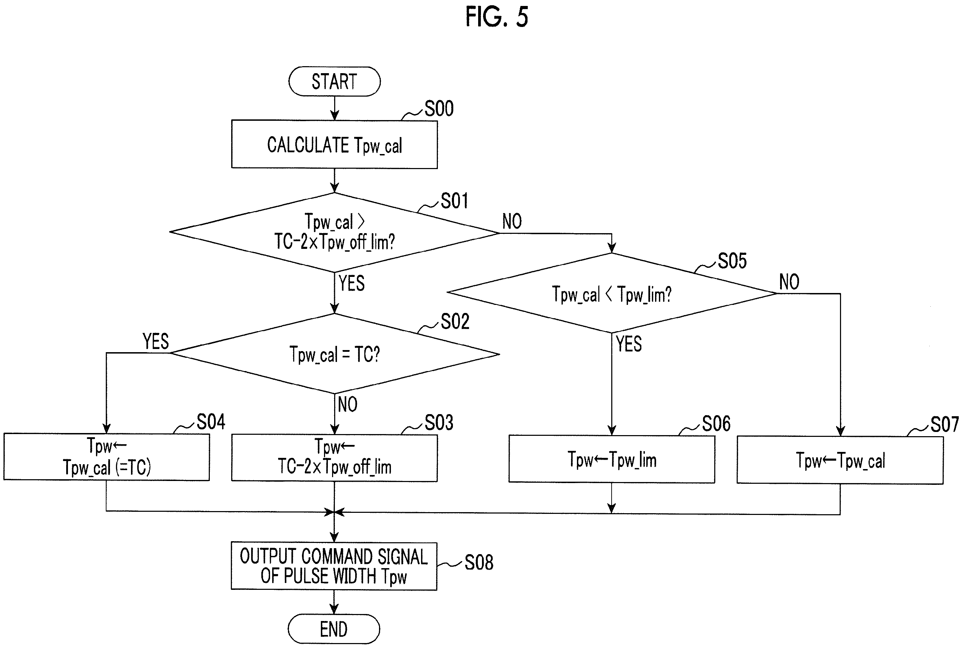

Fig. 5 is a diagram illustrating a process flow of the CPU according to the first embodiment.

The process flow shown in Fig. 5 is executed every time the pulse width of the command signal (Fig. 4) to be finally output by the CPU 10 is determined, for each predetermined carrier cycle TC.

First, the pulse width calculation unit 100 calculates the pulse width calculation value Tpw_cal indicating the pulse width of the command signal, based on the PWM control such that the AC power to be sent to the motor 2 becomes an ideal sinusoidal wave (step S00).

Next, the limit determination unit 101 determines whether or not the pulse width calculation value Tpw_cal calculated in step S00 is larger than a predetermined pulse width upper limit value (step S01). Here, the "pulse width upper limit value" is a value obtained by subtracting twice the off period limit value Tpw_off_lim from the carrier cycle TC.

In a case where the pulse width calculation value Tpw_cal is larger than the pulse width upper limit value (step S01: YES), next, the limit determination unit 101 determines whether or not the pulse width calculation value Tpw_cal coincides with the carrier cycle TC (that is, whether the duty ratio is 100% or not) (step S02).

In a case where the pulse width calculation value Tpw_cal does not coincide with the carrier cycle TC (step S02: NO), the signal output unit 102 sets the pulse width Tpw of the command signal to be finally output as the pulse width upper limit value (a value obtained by subtracting twice the off period limit value Tpw_off_lim from the carrier cycle TC) (step S03).

On the other hand, in a case where the pulse width calculation value Tpw_cal coincides with the carrier cycle TC (step S02: YES), the signal output unit 102 sets the pulse width Tpw of the command signal to be finally output to the pulse width calculation value (= carrier cycle TC (that is, the duty ratio is 100%)) (step S04).

Further, in a case where the pulse width calculation value Tpw_cal is equal to or less than the pulse width upper limit value (step S01: NO), next, the limit determination unit 101 determines whether or not the pulse width calculation value Tpw_cal is smaller than the predetermined pulse width lower limit value Tpw_lim (step S05). Here, the "pulse width lower limit value" is a minimum value of the pulse width Tpw at which it is guaranteed that the high voltage ICs 110, 111, and 112 (Fig. 1) do not cause a malfunction.

In a case where the pulse width calculation value Tpw_cal is smaller than the pulse width lower limit value Tpw_lim (step S05: YES), the signal output unit 102 sets the pulse width Tpw of the command signal to be finally output, as a pulse width lower limit value Tpw_lim (step S06) .

On the other hand, in a case where the pulse width calculation value Tpw_cal is larger than the pulse width lower limit value Tpw_lim (step S05: NO), the signal output unit 102 sets the pulse width Tpw of the command signal to be finally output, as a pulse width calculation value Tpw_cal (step S07)).

The signal output unit 102 outputs the command signal of the pulse width Tpw determined at any of steps S03, S04, S06, and S07 toward each of the high voltage ICs 110, 111, and 112 (step S08).

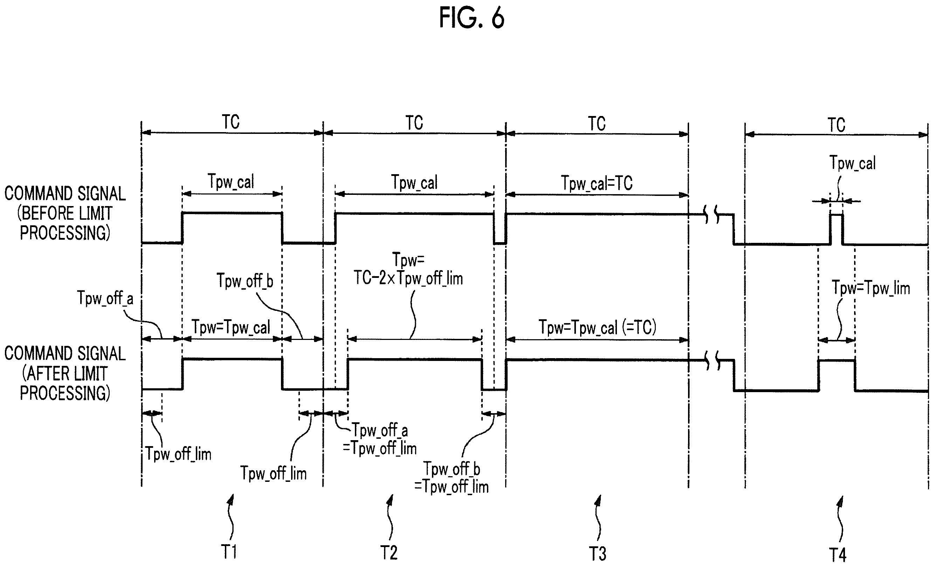

Fig. 6 is a diagram for explaining an example of a process of the CPU according to the first embodiment.

Fig. 6 shows a waveform before application of limit processing of a command signal (a waveform based only on the pulse width calculation value Tpw_cal) and a waveform after application of limit processing of a command signal (the waveform that the CPU 10 actually outputs, after the process flow shown in Fig. 5).

The pulse width calculation unit 100 calculates a pulse width calculation value Tpw_cal to be output at a certain carrier cycle TC (step S00 in Fig. 5). In a case where the pulse width calculation value Tpw_cal calculated here is the above-described pulse width lower limit value Tpw_lim or more and the pulse width upper limit value (TC-2×Tpw_off_lim) or less (corresponding to NO in step S05 in Fig. 5), the signal output unit 102 outputs a command signal having the same pulse width Tpw (Tpw = Tpw_cal) as the pulse width calculation value Tpw_cal (see period T1 in Fig. 6).

Here, the signal output unit 102 outputs a command signal of the pulse width Tpw such that the starting off period Tpw_off_a and the ending off period Tpw_off_b in the carrier cycle TC coincide with each other for each carrier cycle TC. That is, the signal output unit 102 turns on the command signal after the lapse of the starting off period Tpw_off_a from the start time of the carrier cycle TC, and turns off the command signal after the lapse of the pulse width Tpw (= Tpw_cal) from the turn-on time. Here, the ending off period Tpw_off_b, which is a period from the turn-off point of the command signal to the end point of the carrier cycle TC, is adjusted to be the same time interval as the starting off period Tpw_off_a (Tpw_off_b = Tpw_off_a).

In the period T1 of Fig. 6, since the pulse width Tpw is smaller than the pulse width upper limit value, both the starting off period Tpw_off_a and the ending off period Tpw_off_b are longer than the off period limit value Tpw_off_lim. Therefore, a malfunction of the PWM control caused by the negative voltage surge does not occur in the carrier cycle TC in the period T1 and the carrier cycle TC following the carrier cycle TC.

In a case where the pulse width calculation value Tpw_cal is larger than the pulse width upper limit value (TC-2×Tpw_off_limit) and does not coincide with the carrier cycle TC (corresponding to NO in step S 02 of Fig. 5), the signal output unit 102 outputs a command signal having the same pulse width Tpw (Tpw = TC-2×Tpw_off_lim) as the pulse width upper limit value (see a period T2 in Fig. 6).

Here, if it is attempted to output a command signal having a pulse width larger than the pulse width upper limit value (TC-2×Tpw_off_limit), both the starting off period Tpw_off_a and the ending off period Tpw_off_b become smaller than the off period limit value Tpw_off_lim. Then, as described with reference to Fig. 4, since the command signal can be turned on during the occurrence of the negative voltage surge, a malfunction can occur in the PWM control.

Therefore, in this case, the signal output unit 102 outputs a command signal with a pulse width indicated by the pulse width upper limit value (TC-2×Tpw_off_limit) instead of the pulse width calculation value Tpw_cal (see the period T2 in Fig. 6). In this case as well, the signal output unit 102 outputs the command signal so that the starting off period Tpw_off_a and the ending off period Tpw_off_b in the carrier cycle TC coincide.

As a result, the starting off period Tpw_off_a and the ending off period Tpw_off_b in the carrier cycle TC both coincide with the off period limit value Tpw_off_lim. That is, a minimum off period (off period limit value Tpw_off_lim) in which a malfunction does not occur is secured in both the starting off period Tpw_off_a and the ending off period Tpw_off_b.

In a case where the pulse width calculation value Tpw_cal coincides with the carrier cycle TC (corresponding to YES in step S02 in Fig. 5), the signal output unit 102 outputs a command signal of the same pulse width Tpw (Tpw = Tpw_cal = TC) as the pulse width calculation value Tpw_cal (TC) (see period T3 in Fig. 6).

Here, in a case where a command signal whose pulse width calculation value Tpw_cal coincides with the carrier cycle TC (duty ratio of 100%) is output, there is no off period in the carrier cycle TC (the starting off period Tpw_off_a and the ending off period Tpw_off_b), from the first. Therefore, in this case, since negative voltage surge cannot occur in the carrier cycle TC, the signal output unit 102 outputs a command signal having the pulse width Tpw according to the calculated pulse width calculation value Tpw_cal (see period T3 in Fig. 6).

In a case where the pulse width calculation value Tpw_cal is smaller than the pulse width lower limit value Tpw_lim (corresponding to YES in step S05 in Fig. 5), the signal output unit 102 outputs a command signal of the same pulse width Tpw (Tpw = Tpw_lim) as the pulse width lower limit value Tpw_lim (see the period T4 in Fig. 6).

Here, if it is attempted to output a command signal having a pulse width smaller than the pulse width lower limit value Tpw_lim, a malfunction due to the pulse width of the command signal being too small in the high voltage ICs 110, 111, 112 may occur.

Therefore, in this case, the signal output unit 102 outputs a command signal with a pulse width indicated by the pulse width lower limit value Tpw_lim instead of the pulse width calculation value Tpw_cal (see the period T4 in Fig. 6). In this case as well, the signal output unit 102 outputs the command signal so that the starting off period Tpw_off_a and the ending off period Tpw_off_b in the carrier cycle TC coincide.

As a result, the pulse width Tpw of the command signal in the carrier cycle TC coincides with the pulse width lower limit value Tpw_lim. That is, a minimum pulse width (pulse width lower limit value Tpw_lim) that does not cause a malfunction is secured.

### (Action and Effect)

As described above, when the pulse width calculation value Tpw_cal is larger than the predetermined pulse width upper limit value, the CPU 10 (signal output unit 102) according to the first embodiment outputs a command signal having a pulse width indicated by the pulse width upper limit value, instead of the pulse width calculation value Tpw_cal.

By doing so, since the pulse width of the command signal occupying the carrier cycle TC is not equal to or larger than the predetermined value (pulse width upper limit value), an off period in which a malfunction does not occur in the command signal is secured. Therefore, the occurrence of malfunction based on the negative voltage surge can be suppressed, without adding a separate element.

As described above, according to the CPU 10 of the first embodiment, the above-described pulse width upper limit value is a value obtained by subtracting twice the predetermined off period limit value Tpw_off_lim from the carrier cycle TC. In addition, the off period limit value Tpw_off_lim is defined as a period from a time when the command signal is turned off to a time of recovery from negative voltage surge generated due to turning off of a switching element (for example, the switching element 120H) which operates based on the command signal (see Fig. 4) .

By doing so, the off period limit value Tpw_off_lim can be defined as the shortest time to the recovery from the negative voltage surge, so it is possible to suppress a reduction in the power conversion efficiency which can occur in a case of lowering the pulse width Tpw of the command signal from the original pulse width calculation value Tpw_cal to the pulse width upper limit value (TC-2×Tpw_lim_off).

As described above, in a case where the pulse width calculation value Tpw_cal coincides with the carrier cycle TC (in a case where the duty ratio is 100%), the CPU 10 according to the first embodiment outputs a command signal having a pulse width indicated by a pulse width calculation value Tpw_cal (= TC) that coincides with the carrier cycle TC, instead of the pulse width upper limit value.

By doing so, the pulse width Tpw of the command signal is not reduced to the pulse width upper limit value only in a case where the duty ratio is 100%, so that it is possible to further suppress the reduction in power conversion efficiency.

As described above, in a case where the pulse width calculation value Tpw_cal is smaller than the predetermined pulse width lower limit value Tpw_lim, the CPU 10 according to the first embodiment outputs a command signal having a pulse width indicated by the pulse width lower limit value Tpw_lim, instead of the pulse width calculation value Tpw_cal.

By doing so, since a command signal having a pulse width smaller than the pulse width lower limit value Tpw_lim is not output the high voltage ICs 110, 111, 112, it is possible to prevent a malfunction caused by the pulse width of the command signal being too small.

In the inverter 1 according to the first embodiment, the CPU 10, the high voltage ICs 110, 111, and 112, and the switching element IC 12 are mounted as separate IC packages.

By doing so, for example, an inverter can be manufactured using only an inexpensive high voltage IC and a switching element, rather than using an IC in which a high voltage IC and a switching element are packaged together, it is possible to achieve a cost reduction in an inverter.

### <Second Embodiment>

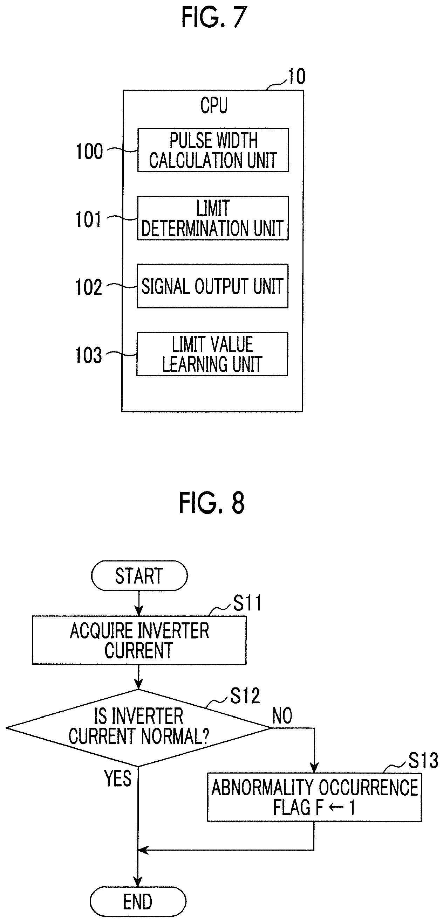

Next, an inverter according to a second embodiment will be described with reference to Fig. 7 to Fig. 10. The circuit configuration of the inverter according to the second embodiment is similar to that of the first embodiment (Figs. 1 and 2).

### (Functional Configuration of CPU)

Fig. 7 is a diagram illustrating a functional configuration of the CPU according to the second embodiment.

As illustrated in Fig. 7, the CPU 10 according to the second embodiment further includes a limit value learning unit 103 in addition to the first embodiment.

Hereinafter, the function of the limit value learning unit 103 will be described in detail.

### (CPU Process flow)

Fig. 8 is a diagram illustrating a first process flow of the CPU according to the second embodiment.

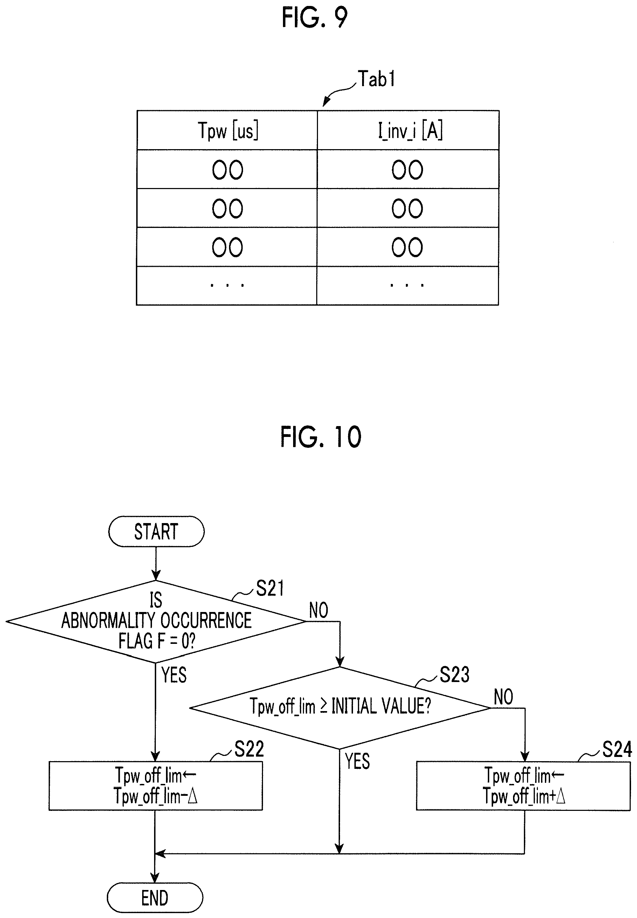

Fig. 9 is a diagram for explaining the function of a limit value learning unit according to the second embodiment.

First, with reference to Figs. 8 and 9, a first process flow executed by the limit value learning unit 103 will be described.

The first process flow shown in Fig. 8 is executed, for example, for each carrier cycle TC.

First, the limit value learning unit 103 acquires an inverter current measurement value I_inv_s which is a measurement result of the inverter current by the current sensor 13 (step S11).

Next, the limit value learning unit 103 determines whether or not the acquired inverter current measurement value I_inv_s is normal (step S12). Here, the limit value learning unit 103 determines whether or not the acquired inverter current measurement value I_inv_s is normal, with reference to the reference table Tab1 prepared in advance (Fig. 9) .

Fig. 9 illustrates an example of the reference table Tab1 included in the limit value learning unit 103.

In the reference table Tab1, the pulse width Tpw[µs] of the command signal output from the signal output unit 102 and the inverter current assumed value I_inv_i[A] corresponding to the pulse width Tpw are recorded in association with each other.

Here, when a command signal having a certain pulse width Tpw is output from the CPU 10, the switching elements 120H, 120L are turned on or off according to the pulse width Tpw, so that the inverter current corresponding to the pulse width Tpw flows. In the reference table Tab1, an inverter current assumed value I_inv_i indicative of an inverter current assumed for each pulse width Tpw is defined based on a measurement result of the inverter current obtained in advance or the like.

In a case where a malfunction of the PWM control based on negative voltage surge or the like occurs, an inverter current which is significantly different from the inverter current assumed for each pulse width Tpw can be generated.

In step S12, the limit value learning unit 103 compares the inverter current assumed value I_inv_i (Fig. 9) corresponding to the pulse width Tpw of the command signal output in a certain carrier cycle TC and the inverter current measurement value I_inv_s which is measured in the carrier cycle TC (acquired in step S11). In a case where the difference between the acquired inverter current measurement value I_inv_s and the inverter current assumed value I_inv_i is within a range of a predefined allowable error δ (I_inv_i-δ < I_inv_s < I_inv_i+δ), the limit value learning unit 103 determines that the inverter current measurement value I_inv_s is normal (step S12: YES), and ends the first process flow.

On the other hand, in a case where the difference between the acquired inverter current measurement value I_inv_s and the inverter current assumed value I_inv_i is not within the range of the predefined allowable error δ, it is determined that the inverter current measurement value I_inv_s is abnormal (step S12: NO).

In this case, the limit value learning unit 103 substitutes 1 for a predetermined abnormality occurrence flag F (initial value is 0) (step S13), and ends the first process flow.

Fig. 10 is a diagram illustrating a second process flow of the CPU according to the second embodiment.

Next, a second process flow executed by the limit value learning unit 103 will be described.

The second process flow shown in Fig. 10 is executed at each carrier cycle TC or at each predefined predetermined period longer than the carrier cycle TC.

The limit value learning unit 103 determines whether or not the abnormality occurrence flag F is 0 (step S21).

In the case where the abnormality occurrence flag F is 0 (step S21: YES), the limit value learning unit 103 reduces the off period limit value Tpw_off_lim from a value (for example, 2.5 µs) defined at a current time by a predetermined minute value Δ (for example, Δ = 0.1 µs) (step S22).

Here, in the first process flow, in a case where no abnormality has occurred in the inverter current measurement value I_inv_s, the value of the abnormality occurrence flag F remains 0. Therefore, according to the second process flow of the limit value learning unit 103, as long as a state in which no abnormality has occurred in the inverter current measurement value I_inv_s is maintained, the off period limit value Tpw_off_lim gradually decreases by a minute value Δ.

On the other hand, in a case where the abnormality occurrence flag F is 1 (step S21: NO), the limit value learning unit 103 determines whether or not the off period limit value Tpw_off_lim defined at a current time is an initial value (for example, 2.5 µs) (step S23).

In a case where the off period limit value Tpw_off_lim is the initial value, the limit value learning unit 103 returns the abnormality occurrence flag F to 0 without changing the off period limit value Tpw_off_lim, and ends the second process flow.

In a case where the off period limit value Tpw_off_lim is not the initial value, the limit value learning unit 103 increases the off period limit value Tpw_off_lim from a value defined at a current time by a predetermined minute value Δ (for example, Δ = 0.1 µs) (step S24). Then, the limit value learning unit 103 returns the abnormality occurrence flag F to 0, and ends the second process flow.

Here, in the first process flow, in a case where abnormality occurs in the inverter current measurement value I_inv_s, the value of the abnormality occurrence flag F is set to 1. Therefore, according to the second process flow of the limit value learning unit 103, in a case where an abnormality occurs in the inverter current measurement value I_inv_s, the off period limit value Tpw_off_lim increases by a minute value Δ.

### (Action and Effect)

As described above, the CPU 10 (limit value learning unit 103) according to the second embodiment determines whether or not the measurement value of the inverter current (the inverter current measurement value I_inv_s) is normal, based on the pulse width Tpw of the command signal. In a case where it is determined that the measurement value is abnormal, the CPU 10 increases the off period limit value Tpw_off_lim by a predetermined minute value Δ and gradually decreases the pulse width upper limit value.

By doing so, in a state where a malfunction is likely to occur in the PWM control, the off period limit value Tpw_off_lim increases (the pulse width upper limit value decreases), and it transitions to a state in which malfunction hardly occurs. Therefore, the occurrence of a malfunction based on the negative voltage surge can be suppressed.

Further, as described above, in a case of determining that the inverter current measurement value I_inv_s is normal, the CPU 10 according to the second embodiment decreases the off period limit value Tpw_off_lim by a predetermined minute value A and gradually raises the pulse width upper limit value.

By doing so, in a state where a malfunction does not occur in the PWM control, the off period limit value Tpw_off_lim gradually decreases (the pulse width upper limit value increases). Therefore, it is possible to suppress a reduction in power conversion efficiency that can occur in a case where the pulse width Tpw of the command signal is reduced from the original pulse width calculation value Tpw_cal to the pulse width upper limit value.

### <Third Embodiment>

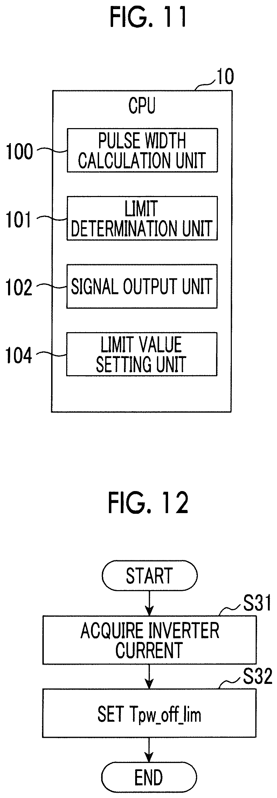

Next, an inverter according to a third embodiment will be described with reference to Fig. 11 to Fig. 13. The circuit configuration of the inverter according to the third embodiment is similar to that of the first embodiment (Figs. 1 and 2).

### (Functional Configuration of CPU)

Fig. 11 is a diagram illustrating a functional configuration of the CPU according to the third embodiment.

As illustrated in Fig. 11, the CPU 10 according to the third embodiment further includes a limit value setting unit 104 in addition to the first embodiment.

Hereinafter, the function of the limit value setting unit 104 will be described in detail.

### (CPU Process flow)

Fig. 12 is a diagram illustrating a process flow of the CPU according to the third embodiment.

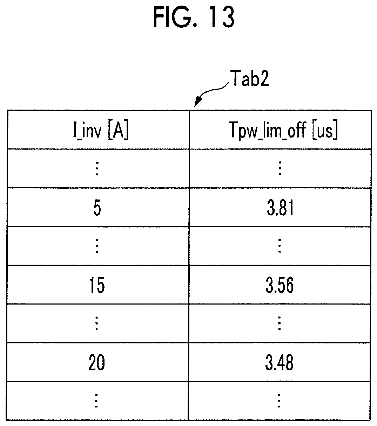

Fig. 13 is a diagram for explaining the function of the limit value setting unit according to the third embodiment.

Hereinafter, the process of the limit value setting unit 104 will be described with reference to Figs. 12 and 13.

The limit value setting unit 104 acquires an inverter current measurement value I_inv_s which is a measurement result by the current sensor 13 of the inverter current (step S31).

Next, the limit value setting unit 104 sets the off period limit value Tpw_off_lim based on the acquired value of the inverter current measurement value I_inv_s (step S32). Here, the limit value setting unit 104 sets the off period limit value Tpw_off_lim based on the acquired inverter current measurement value I_inv_s, while referring to the reference table Tab2 (Fig. 13) prepared in advance.

Fig. 13 illustrates an example of the reference table Tab2 included in the limit value setting unit 104.

In the reference table Tab2, an inverter current measurement value I_inv_s [A] and the off period limit value Tpw_off_lim to be set are recorded in associated with each other.

Here, it is known that in the recovery period tvs (Fig. 4), the delay time (time from the time tc to the time td) from the turning off of the gate voltage Vg until the load driving voltage Vs reaches 0 V changes greatly depending on the size of the inverter current. Specifically, a general switching element (such as the switching element 120H) has a characteristic that the delay time (time tc to time td) decreases as the inverter current increases. Therefore, the recovery period tvs decreases as the inverter current increases.

In the reference table Tab2, the off period limit value Tpw_off_lim corresponding to each inverter current measurement value I_inv_s is defined based on the measurement result of the recovery period tvs which is acquired in advance or the like.

The limit value setting unit 104 repeatedly executes steps S 31 and S32 to sequentially change the off period limit value Tpw_off_lim according to the inverter current measurement value I_inv_s.

### (Action and Effect)

As described above, the CPU 10 (limit value setting unit 104) according to the third embodiment sets the off period limit value Tpw_off_lim (that is, the pulse width upper limit value) to a value corresponding to the inverter current measurement value I_inv_s.

By doing so, the off period limit value Tpw_off_lim is set to the shortest period according to the inverter current, so that it is possible to further suppress the reduction in power conversion efficiency.

### <Modification example of each embodiment>

Although the inverter 1 and the CPU 10 according to the first to third embodiments have been described above in detail, the specific aspects of the inverter 1 and the CPU 10 are not limited to the above-described ones, and it is possible to add various design changes and the like within the scope not departing from the gist.

For example, in the explanation of the first embodiment, it is assumed that the signal output unit 102 limits the pulse width Tpw such that the starting off period Tpw_off_a (and the ending off period Tpw_off_b) in one carrier cycle TC to be at least the time width of the off period limit value Tpw_off_lim. However, other embodiments are not limited to this aspect.

The signal output unit 102 according to another embodiment may limit the pulse width in a range in which the sum of the ending off period Tpw_off_b in a one-preceding carrier cycle TC and the starting off period Tpw_off_a in the current carrier cycle TC is not less than the off period limit value Tpw_off_lim.

More specifically, the signal output unit 102 may refer to the ending off period Tpw_off_b' in a one-preceding carrier cycle TC and set a value obtained by subtracting Tpw_off_b' from the off period limit value Tpw_off_lim defined based on the recovery period tvs as the off period limit value applied to the current carrier cycle TC.

By doing so, it is possible to limit that the off period between the pulse (on period) output in the one-preceding carrier cycle TC and the pulse (on period) output in the current carrier cycle TC does not become smaller than.the off period limit value Tpw_off_lim. Thus, it is possible to further suppress a reduction in power conversion efficiency.

In each of the above-described embodiments, the procedures of the various processes of the CPU 10 described above are stored in a computer-readable recording medium in the form of a program, and the above-described various processes may be performed by the computer reading and executing the program. Here, the computer-readable recording medium means a magnetic disk, a magneto-optical disk, a CD-ROM, a DVD-ROM, a semiconductor memory, or the like. Further, the computer program may be delivered to a computer through a communication line, and the computer receiving the distribution may execute the program.

The program may be for realizing part of the above-described functions. Further, the program may be a so-called difference file (difference program) that can realize the above-described function in combination with a program already recorded in the computer system. Furthermore, the CPU 10 may be configured with one computer or a plurality of computers connected to be communicable.

Exemplary embodiments of the present invention are described above, but these exemplary embodiments are presented as an example, and are not intended to limit the scope of the invention. These embodiments can be realized in a variety of other forms, and various omissions, replacements and changes can be made, without departing from the scope of the invention. These embodiments and variations thereof are included in the scope of the invention, and included in the scope of the invention and their equivalents as described in the appended claims.

### Industrial Applicability

According to the control device, the inverter, the control method and the program, described above, it is possible to suppress the occurrence of a malfunction based on negative voltage surge without adding a separate element.

### Reference Signs List

1 INVERTER
10 CPU (CONTROL DEVICE)
100 PULSE WIDTH CALCULATION UNIT
101 LIMIT DETERMINATION UNIT
102 SIGNAL OUTPUT UNIT
103 LIMIT VALUE LEARNING UNIT
104 LIMIT VALUE SETTING UNIT
110, 111, 112 HIGH VOLTAGE IC (SWITCHING ELEMENT DRIVE CIRCUIT)
110A HIGH-SIDE DRIVE CIRCUIT
110B LOW-SIDE DRIVE CIRCUIT
12 SWITCHING ELEMENT IC
120H, 120L, 121H, 121L, 122H, 122L SWITCHING ELEMENT
13 CURRENT SENSOR
2 MOTOR
D DIODE ELEMENT
CH, CL CAPACITOR ELEMENT

## Claims

1. A control device (10) which performs pulse width modulation control of an inverter (12), comprising:
a pulse width calculation unit (100) that calculates a pulse width calculation value (Tpw_cal) indicating a pulse width of a command signal to be output at each carrier cycle (TC) of the pulse width modulation; and
a signal output unit (102) that outputs the command signal of the pulse width indicated by the pulse width calculation value such that a starting off period (Tpw_off_a) and an ending off period (Tpw_off_b) in the carrier cycle coincide with each other, at each carrier cycle, wherein the starting off period (Tpw_off_a) is a period from the start point of the carrier cycle (TC) and the turn-on point of the command signal and the ending off period (Tpw_off_b)is a period from the turn-off point of the command signal to the end point of the carrier cycle (TC),
wherein the signal output unit is configured to define an off period limit value (Tpw_off_lim) as a period from a time when the command signal is turned off to a time of recovery from negative voltage surge generated due to turning off of an inverter switching element which operates based on the command signal, set a pulse width upper limit value as a value obtained by subtracting a value based on the off period limit value from the carrier cycle, and
in a case where the pulse width calculation value is larger than the pulse width upper limit value, output the command signal of a pulse width indicated by the pulse width upper limit value, instead of the pulse width calculation value.

2. The control device according to claim 1, wherein the pulse width upper limit value is a value obtained by subtracting twice a predetermined off period limit value from the carrier cycle.

3. The control device according to claim 1 or 2,
wherein in a case where the pulse width calculation value coincides with the carrier cycle, the signal output unit further outputs the command signal of a pulse width indicated by the pulse width calculation value coinciding with the carrier cycle, instead of the pulse width upper limit value.

4. The control device according to any one of claims 1 to 3,
wherein in a case where the pulse width calculation value is smaller than a predetermined pulse width lower limit value, the signal output unit further outputs the command signal of a pulse width indicated by the pulse width lower limit value, instead of the pulse width calculation value.

5. The control device according to any one of claims 1 to 4, further comprising:
a limit value learning unit that determines whether or not a measurement value of an inverter current flowing through the inverter is normal, based on a pulse width of the command signal, and lowers the pulse width upper limit value in a case where it is determined that the measurement value of the inverter current is abnormal.

6. The control device according to claim 5,
wherein the limit value learning unit raises the pulse width upper limit value in a case where it is determined that the measurement value of the inverter current is normal.

7. The control device according to any one of claims 1 to 4, further comprising:
a limit value setting unit that sets the pulse width upper limit value to a value corresponding to a measurement value of an inverter current flowing through the inverter.

8. An inverter comprising:
the control device according to any one of claims 1 to 7;
a switching element drive circuit that drives a switching element based on the command signal from the control device; and
the switching element.

9. The inverter according to claim 8,
wherein the control device, the switching element drive circuit, and the switching element are implemented in different IC packages, respectively.

10. A control method for performing pulse width modulation control of an inverter, comprising:
a pulse width calculation step of calculating a pulse width calculation (Tpw_cal) indicating a pulse width of a command signal to be output at each carrier (TC) of the pulse width modulation; and
a signal output step of outputting the command signal of the pulse width indicated by the pulse width calculation value such that a starting off period (Tpw_off_a) and an ending off period (Tpw_off_b) in the carrier cycle coincide with each other, at each carrier cycle (TC), wherein the starting off period (Tpw_off_a) is a period from the start point of the carrier cycle (TC) and the turn-on point of the command signal and the ending off period (Tpw_off_b) is a period from the turn-off point of the command signal to the end point of the carrier cycle (TC),
wherein in the signal output step,
an off period limit value (Tpw_off_lim) is defined as a period from a time when the command signal is turned off to a time of recovery from negative voltage surge generated due to turning off of an inverter switching element which operates based on the command signal,
a pulse width upper limit value is set as a value obtained by subtracting a value based on the off period limit value from the carrier cycle, and
in a case where the pulse width calculation value is larger than a predetermined pulse width upper limit value, the command signal of a pulse width indicated by the pulse width upper limit value is output instead of the pulse width calculation value.

11. A program causing a control device which performs pulse width modulation control of an inverter to function as:
a pulse width calculation unit that calculates a pulse width calculation value indicating a pulse width of a command signal to be output at each carrier cycle (TC) of the pulse width modulation; and
a signal output unit that outputs the command signal of the pulse width indicated by the pulse width calculation value such that a starting off period (Tpw_off_a) and an ending off period (Tpw_off_b) in the carrier cycle coincide with each other, at each carrier cycle (TC), wherein the starting off period (Tpw_off_a) is a period from the start point of the carrier cycle (TC) and the turn-on point of the command signal and the ending off period (Tpw_off_b)is a period from the turn-off point of the command signal to the end point of the carrier cycle (TC),
wherein the signal output unit
defines an off period limit value (Tpw_off_lim) as a period from a time when the command signal is turned off to a time of recovery from negative voltage surge generated due to turning off of an inverter switching element which operates based on the command signal,
sets a pulse width upper limit value as a value obtained by subtracting a value based on the off period limit value from the carrier cycle, and
in a case where the pulse width calculation value is larger than the pulse width upper limit value, outputs the command signal of a pulse width indicated by the pulse width upper limit value, instead of the pulse width calculation value.

## Patentansprüche

1. Steuerungsvorrichtung (10), welche eine Pulsbreitemodulationssteuerung eines Wechselrichters (12) durchführt, aufweisend:
eine Pulsbreiteberechnungseinheit (100), die einen Pulsbreiteberechnungswert (Tpw_cal) berechnet, der eine Pulsbreite eines zu jedem Trägerzyklus (TC) der Pulsbreitemodulation auszugebenden Befehlssignals anzeigt; und
eine Signalausgabeeinheit (102), die das Befehlssignal der durch den Pulsbreiteberechnungswert angezeigten Pulsbreite derart ausgibt, dass eine Start-Aus-Zeitdauer (Tpw_off_a) und eine Ende-Aus-Zeitdauer (Tpw_off_b) in dem Trägerzyklus miteinander übereinstimmen, zu jedem Trägerzyklus, wobei die Start-Aus-Zeitdauer (Tpw_off_a) eine Zeitdauer von dem Startpunkt des Trägerzyklus (TC) und dem Einschaltpunkt des Befehlssignals darstellt, und die Ende-Aus-Zeitdauer (Tpw_off_b) eine Zeitdauer von dem Ausschaltpunkt des Befehlssignals zu dem Endpunkt des Trägerzyklus (TC) darstellt,
wobei die Signalausgabeeinheit konfiguriert ist, um
einen Aus-Zeitdauer-Grenzwert (Tpw_off_lim) als eine Zeitdauer von einem Zeitpunkt, wenn das Befehlssignal ausgeschaltet wird, zu einem Zeitpunkt einer Wiederherstellung von einem negativen Spannungsstoß zu definieren, der aufgrund eines Ausschaltens eines Wechselrichterumschaltelements, welches basierend auf dem Befehlssignal betrieben wird, erzeugt ist,
einen oberen Pulsbreitegrenzwert als einen Wert einzustellen, der durch Subtrahieren eines Werts basierend auf dem Aus-Zeitdauer-Grenzwert von dem Trägerzyklus erhalten ist, und
für den Fall, dass der Pulsbreiteberechnungswert größer als der obere Pulsbreitegrenzwert ist, das Befehlssignal einer durch den oberen Pulsbreitegrenzwert angezeigten Pulsbreite anstelle des Pulsbreiteberechnungswerts auszugeben.

2. Steuerungsvorrichtung nach Anspruch 1,
wobei der obere Pulsbreitegrenzwert einen Wert darstellt, der durch zweimaliges Subtrahieren eines vorbestimmten Aus-Zeitdauer-Grenzwerts von dem Trägerzyklus erhalten ist.

3. Steuerungsvorrichtung nach Anspruch 1 oder 2,
wobei, für den Fall, dass der Pulsbreiteberechnungswert mit dem Trägerzyklus übereinstimmt, die Signalausgabeeinheit ferner das Befehlssignal einer Pulsbreite, die durch den Pulsbreiteberechnungswert angezeigt ist, der mit dem Trägerzyklus übereinstimmt, anstelle des oberen Pulsbreitegrenzwerts ausgibt.

4. Steuerungsvorrichtung nach einem der Ansprüche 1 bis 3,
wobei, für den Fall, dass der Pulsbreiteberechnungswert kleiner als ein vorbestimmter unterer Pulsbreitegrenzwert ist, die Signalausgabeeinheit ferner das Befehlssignal einer Pulsbreite, die durch den unteren Pulsbreitegrenzwert angezeigt ist, anstelle des Pulsbreiteberechnungswerts ausgibt.

5. Steuerungsvorrichtung nach einem der Ansprüche 1 bis 4, ferner aufweisend:
eine Grenzwert-Lerneinheit, die bestimmt, ob ein Messwert eines durch den Wechselrichter fließenden Wechselrichterstroms normal ist oder nicht, basierend auf einer Pulsbreite des Befehlssignals, und den oberen Pulsbreitegrenzwert für den Fall verringert, dass bestimmt wird, dass der Messwert des Wechselrichterstroms nicht normal ist.

6. Steuerungsvorrichtung nach Anspruch 5,
wobei die Grenzwert-Lerneinheit den oberen Pulsbreitegrenzwert für den Fall erhöht, dass bestimmt wird, dass der Messwert des Wechselrichterstroms normal ist.

7. Steuerungsvorrichtung nach einem der Ansprüche 1 bis 4, ferner aufweisend:
eine Grenzwert-Einstellungseinheit, die den oberen Pulsbreitegrenzwert auf einen Wert korrespondierend zu einem Messwert eines durch den Wechselrichter fließenden Wechselrichterstroms einstellt.

8. Wechselrichter, aufweisend:
die Steuerungsvorrichtung nach einem der Ansprüche 1 bis 7;
eine Umschaltelement-Antriebsschaltung, die ein Umschaltelement basierend auf dem Befehlssignal von der Steuerungsvorrichtung antreibt; und
das Umschaltelement.

9. Wechselrichter nach Anspruch 8,
wobei die Steuerungsvorrichtung, die Umschaltelement-Antriebsschaltung und das Umschaltelement jeweils in unterschiedlichen IC-Paketen implementiert sind.

10. Steuerungsverfahren zum Durchführen einer Pulsbreitemodulationssteuerung eines Wechselrichters, aufweisend:
einen Pulsbreiteberechnungsschritt zum Berechnen einer Pulsbreiteberechnung (Tpw_cal), die eine Pulsbreite eines mit jedem Träger (TC) der Pulsbreitemodulation auszugebenden Befehlssignals anzeigt; und
einen Signalausgabeschritt zum Ausgeben des Befehlssignals der durch den Pulsbreiteberechnungswert angezeigten Pulsbreite derart, dass eine Start-Aus-Zeitdauer (Tpw_off_a) und eine Ende-Aus-Zeitdauer (Tpw_off_b) in dem Trägerzyklus miteinander übereinstimmen, zu jedem Trägerzyklus (TC), wobei die Start-Aus-Zeitdauer (Tpw_off_a) eine Zeitdauer von dem Startpunkt des Trägerzyklus (TC) und dem Einschaltpunkt des Befehlssignals darstellt, und die Ende-Aus-Zeitdauer (Tpw_off_b) eine Zeitdauer von dem Ausschaltpunkt des Befehlssignals zu dem Endpunkt des Trägerzyklus (TC) darstellt,
wobei in dem Signalausgabeschritt
ein Aus-Zeitdauer-Grenzwert (Tpw_off_lim) als eine Zeitdauer von einem Zeitpunkt definiert ist, wenn das Befehlssignal ausgeschaltet wird, zu einem Zeitpunkt einer Wiederherstellung von einem negativen Spannungsstoß, der aufgrund eines Ausschaltens eines Wechselrichterumschaltelements, welches basierend auf dem Befehlssignal betrieben wird, erzeugt ist,
ein oberer Pulsbreitegrenzwert als ein Wert eingestellt ist, der durch Subtrahieren eines Werts basierend auf dem Aus-Zeitdauer-Grenzwert von dem Trägerzyklus erhalten ist, und
für den Fall, dass der Pulsbreiteberechnungswert größer als ein vorbestimmter oberer Pulsbreitegrenzwert ist, das Befehlssignal einer Pulsbreite, die durch den oberen Pulsbreitegrenzwert angezeigt ist, anstelle des Pulsbreiteberechnungswerts ausgegeben wird.

11. Programm, das bewirkt, dass eine Steuerungsvorrichtung, welche eine Pulsbreitemodulationssteuerung eines Wechselrichters durchführt, als Folgendes fungiert:
eine Pulsbreiteberechnungseinheit, die einen Pulsbreiteberechnungswert berechnet, der eine Pulsbreite eines zu jedem Trägerzyklus (TC) der Pulsbreitemodulation auszugebenden Befehlssignals anzeigt; und
eine Signalausgabeeinheit, die das Befehlssignal der durch den Pulsbreiteberechnungswert angezeigten Pulsbreite derart ausgibt, dass eine Start-Aus-Zeitdauer (Tpw_off_a) und eine Ende-Aus-Zeitdauer (Tpw_off_b) in dem Trägerzyklus miteinander übereinstimmen, zu jedem Trägerzyklus (TC), wobei die Start-Aus-Zeitdauer (Tpw_off_a) eine Zeitdauer von dem Startpunkt des Trägerzyklus (TC) und dem Einschaltpunkt des Befehlssignals darstellt, und die Ende-Aus-Zeitdauer (Tpw_off_b) eine Zeitdauer von dem Ausschaltpunkt des Befehlssignals zu dem Endpunkt des Trägerzyklus (TC) darstellt,
wobei die Signalausgabeeinheit
einen Aus-Zeitdauer-Grenzwert (Tpw_off_lim) als eine Zeitdauer von einem Zeitpunkt, wenn das Befehlssignal ausgeschaltet ist, zu einem Zeitpunkt einer Wiederherstellung von einem negativen Spannungsstoß definiert, der aufgrund eines Ausschaltens eines Wechselrichterumschaltelements, welches basierend auf dem Befehlssignal betrieben wird, erzeugt ist,
einen oberen Pulsbreitegrenzwert als einen Wert einstellt, der durch Subtrahieren eines Werts basierend auf dem Aus-Zeitdauer-Grenzwert von dem Trägerzyklus erhalten ist, und
für den Fall, dass der Pulsbreiteberechnungswert größer als der obere Pulsbreitegrenzwert ist, das Befehlssignal einer Pulsbreite, die durch den oberen Pulsbreitegrenzwert angezeigt ist, anstelle des Pulsbreiteberechnungswerts ausgibt.

## Revendications

1. Dispositif de commande (10) qui réalise une commande de modulation de largeur d'impulsion d'un onduleur (12), comprenant :
une unité de calcul de largeur d'impulsion (100) qui calcule une valeur de calcul de largeur d'impulsion (Tpw_cal) indiquant une largeur d'impulsion d'un signal de commande à délivrer à chaque cycle de porteuse (TC) de la modulation de largeur d'impulsion ; et
une unité de sortie de signal (102) qui délivre le signal de commande de la largeur d'impulsion indiquée par la valeur de calcul de largeur d'impulsion de sorte qu'une période de démarrage (Tpw_off_a) et une période de fin (Tpw_off_b) dans le cycle de porteuse coïncident l'une avec l'autre, à chaque cycle de porteuse, la période de démarrage (Tpw_off_a) étant une période débutant du point de départ du cycle de porteuse (TC) et du point d'activation du signal de commande et la période de fin (Tpw_off_b) étant une période allant du point de désactivation du signal de commande à la fin du cycle de porteuse (TC),
dans lequel l'unité de sortie de signal est configurée pour
définir une valeur limite de période d'arrêt (Tpw_off_lim) comme une période allant d'un instant où le signal de commande est désactivé à un instant de récupération après une surtension négative générée à cause de la désactivation d'un élément de commutation d'onduleur qui fonctionne sur la base du signal de commande,
définir une valeur limite supérieure de largeur d'impulsion comme une valeur obtenue en soustrayant une valeur sur la base de la valeur limite de période d'arrêt du cycle de porteuse, et
dans le cas où la valeur de calcul de largeur d'impulsion est plus importante que la valeur limite supérieure de largeur d'impulsion, délivrer le signal de commande d'une largeur d'impulsion indiquée par la valeur limite supérieure de largeur d'impulsion, au lieu de la valeur de calcul de largeur d'impulsion.

2. Dispositif de commande selon la revendication 1,
dans lequel la valeur limite supérieure de largeur d'impulsion est une valeur obtenue en soustrayant deux fois une valeur limite de période d'arrêt prédéterminée du cycle de porteuse.

3. Dispositif de commande selon la revendication 1 ou 2,
dans lequel, dans le cas où la valeur de calcul de largeur d'impulsion coïncide avec le cycle de porteuse, l'unité de sortie de signal délivre en outre le signal de commande d'une largeur d'impulsion indiquée par la valeur de calcul de largeur d'impulsion coïncidant avec le cycle de porteuse, au lieu de la valeur limite supérieure de largeur d'impulsion.

4. Dispositif de commande selon l'une quelconque des revendications 1 à 3,
dans lequel, dans le cas où la valeur de calcul de largeur d'impulsion est inférieure à une valeur limite inférieure de largeur d'impulsion prédéterminée, l'unité de sortie de signal délivre en outre le signal de commande d'une largeur d'impulsion indiquée par la valeur limite inférieure de largeur d'impulsion, au lieu de la valeur de calcul de largeur d'impulsion.

5. Dispositif de commande selon l'une quelconque des revendications 1 à 4, comprenant en outre :
une unité d'apprentissage de valeur limite qui détermine si une valeur de mesure d'un courant d'onduleur circulant à travers l'onduleur est normale ou non, sur la base d'une largeur d'impulsion du signal de commande, et réduit la valeur limite supérieure de largeur d'impulsion dans le cas où il est déterminé que la valeur de mesure du courant d'onduleur est anormale.

6. Dispositif de commande selon la revendication 5,
dans lequel l'unité d'apprentissage de valeur limite augmente la valeur limite supérieure de largeur d'impulsion dans le cas où il est déterminé que la valeur de mesure du courant d'onduleur est normale.

7. Dispositif de commande selon l'une quelconque des revendications 1 à 4, comprenant en outre :
une unité de réglage de valeur limite qui définit la valeur limite supérieure de largeur d'impulsion à une valeur correspondant à une valeur de mesure d'un courant d'onduleur circulant à travers l'onduleur.

8. Onduleur comprenant :
le dispositif de commande selon l'une quelconque des revendications 1 à 7;
un circuit de pilotage d'élément de commutation qui pilote un élément de commutation sur la base du signal de commande provenant du dispositif de commande ; et
l'élément de commutation.

9. Onduleur selon la revendication 8,
dans lequel le dispositif de commande, le circuit de pilotage d'élément de commutation, et l'élément de commutation sont implémentés dans différents boîtiers de circuits intégrés, respectivement.

10. Procédé de commande pour réaliser une commande de modulation de largeur d'impulsion d'un onduleur, comprenant :
une étape de calcul de largeur d'impulsion consistant à calculer une valeur de calcul de largeur d'impulsion (Tpw-cal) indiquant une largeur d'impulsion d'un signal de commande à délivrer à chaque porteuse (TC) de la modulation de largeur d'impulsion ; et
une étape de sortie de signal consistant à délivrer le signal de commande de la largeur d'impulsion indiquée par la valeur de calcul de largeur d'impulsion de sorte qu'une période de démarrage (Tpw_off_a) et une période de fin (Tpw_off_b) dans le cycle de porteuse coïncident l'une avec l'autre, à chaque cycle de porteuse (TC), la période de démarrage (Tpw_off_a) étant une période débutant du point de départ du cycle de porteuse (TC) et du point d'activation du signal de commande et la période de fin (Tpw_off_b) étant une période allant du point de désactivation du signal de commande à la fin du cycle de porteuse (TC),
dans lequel à l'étape de sortie de signal,
une valeur limite de période de d'arrêt (Tpw_off_lim) est définie comme une période allant d'un instant où le signal de commande est désactivé à un instant de récupération après une surtension négative générée à cause de la désactivation d'un élément de commutation d'onduleur qui fonctionne sur la base du signal de commande,
une valeur limite supérieure de largeur d'impulsion est définie comme une valeur obtenue en soustrayant une valeur sur la base de la valeur limite de période d'arrêt du cycle de porteuse, et
dans le cas où la valeur de calcul de largeur d'impulsion est plus importante qu'une valeur limite supérieure de largeur d'impulsion prédéterminée, le signal de commande d'une largeur d'impulsion indiquée par la valeur limite supérieure de largeur d'impulsion est délivré au lieu de la valeur de calcul de largeur d'impulsion.

11. Programme amenant un dispositif de commande qui réalise une commande de modulation de largeur d'impulsion d'un onduleur à fonctionner comme :
une unité de calcul de largeur d'impulsion qui calcule une valeur de calcul de largeur d'impulsion indiquant une largeur d'impulsion d'un signal de commande à délivrer à chaque cycle de porteuse (TC) de la modulation de largeur d'impulsion ; et
une unité de sortie de signal qui délivre le signal de commande de la largeur d'impulsion indiquée par la valeur de calcul de largeur d'impulsion de sorte qu'une période de démarrage (Tpw_off_a) et une période de fin (Tpw_off_b) dans le cycle de porteuse coïncident l'une avec l'autre, à chaque cycle de porteuse (TC), la période de démarrage (Tpw_off_a) étant une période débutant du point de départ du cycle de porteuse (TC) et du point d'activation du signal de commande et la période de fin (Tpw_off_b) étant une période allant du point de désactivation du signal de commande à la fin du cycle de porteuse (TC),
dans lequel l'unité de sortie de signal
définit une valeur limite de période d'arrêt (Tpw_off_lim) comme une période allant d'un instant où le signal de commande est désactivé à un instant de récupération après une surtension négative générée à cause de la désactivation d'un élément de commutation d'onduleur qui fonctionne sur la base du signal de commande,
définit une valeur limite supérieure de largeur d'impulsion comme une valeur obtenue en soustrayant une valeur sur la base de la valeur limite de période d'arrêt du cycle de porteuse, et
dans le cas où la valeur de calcul de largeur d'impulsion est plus importante que la valeur limite supérieure de largeur d'impulsion, délivre le signal de commande d'une largeur d'impulsion indiquée par la valeur limite supérieure de largeur d'impulsion, au lieu de la valeur de calcul de largeur d'impulsion.
